# FASCICULE DE BREVET EUROPEEN

(11) **EP 3 764 390 B1**
(45) Date de publication et mention de la délivrance du brevet: **01.11.2023**
(21) Numéro de dépôt: 20185199.5
(22) Date de dépôt: 10.07.2020
(51) Int. Cl.: H01L 21/311, H01L 29/66

(54) **PROCÉDÉ DE FORMATION D'ESPACEURS D'UN TRANSISTOR**
VERFAHREN ZUR BILDUNG VON ABSTANDHALTERN FÜR EINEN TRANSISTOR
METHOD OF FORMING SPACERS OF A TRANSISTOR

(30) Priorité: 11.07.2019 FR 1907836
(43) Date de publication de la demande: 13.01.2021
(73) Titulaire: Commissariat à l'Energie Atomique et aux Energies Alternatives, 75015 Paris (FR); Centre National de la Recherche Scientifique, 75016 Paris (FR); Université Grenoble Alpes, 38400 Saint-Martin-d'Hères (FR)
(72) Inventeur: POSSEME, Nicolas, 38054 GRENOBLE Cedex 9 (FR); BONVALOT, Marceline, 38320 EYBENS (FR); CHAKER, Ahmad, 38000 GRENOBLE (FR); VALLEE, Christophe, 38660 LE TOUVET (FR)
(74) Mandataire: Hautier, Nicolas

(56) Documents cités:
- EP-A1- 2 876 677
- EP-A1- 3 174 092

## Description

### DOMAINE TECHNIQUE

La présente invention concerne un procédé de réalisation d'espaceurs d'un transistor. Elle trouvera pour application avantageuse la réalisation d'espaceurs sur les flancs d'une grille d'un transistor avec un excellent contrôle dimensionnel et en évitant la formation de résidus ou de défauts sur ou dans la couche active semiconductrice sous-jacente aux éléments précités. Un domaine d'application concerne la réalisation des transistors FinFET ou FDSOI.

### ÉTAT DE LA TECHNIQUE

Les espaceurs d'un transistor couvrent généralement les flancs latéraux de la grille du transistor. Ils prennent appui sur la couche active du transistor au pied de la grille. Les espaceurs permettent de protéger la grille lors de la formation des régions sources et drains du transistor. Ils permettent également d'isoler électriquement la grille vis-à-vis des régions source et drain, et sont en partie destinés à limiter le couplage capacitif parasite entre la grille et ces régions sources et drains.

Un bon contrôle de l'épaisseur de ces espaceurs, et de la morphologie de ces espaceurs au niveau du pied de grille est un facteur clé pour l'amélioration des performances des transistors.

Les espaceurs sont généralement fabriqués en deux étapes:
- une couche de nitrure de silicium est d'abord déposée de façon conforme sur la grille 3 et la couche active 10,
- cette couche de nitrure de silicium est ensuite gravée de façon anisotrope pour éliminer les parties de celle-ci reposant sur la couche active 10 tout en gardant les parties de celle-ci couvrant les flancs latéraux 5 de la grille 3 et destinées à former des espaceurs 112.

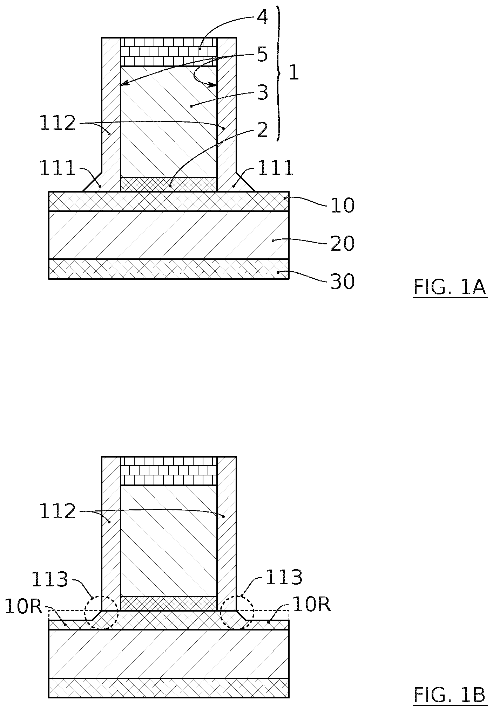

La gravure anisotrope conduit généralement à l'une ou l'autre des situations suivantes illustrées en figures 1A et 1 B:
- la couche active 10 est préservée mais les espaceurs 112 présentent un pied 111 (situation de sous-gravure illustrée à la figure 1A),
- les espaceurs 112 présentent un profil vertical mais la couche active 10R est endommagée (situation de sur-gravure illustrée à la figure 1B).

Avec la réduction des dimensions des transistors et l'apparition de nouvelles architectures de transistors, notamment de transistors nécessitant la formation d'espaceurs au-dessus d'une couche active de faibles épaisseurs, ces situations de sous-gravure et sur-gravure présentent des inconvénients particulièrement préjudiciables. Ces inconvénients sont particulièrement préjudiciables dans les transistors de type FinFET, acronyme du vocable anglais Fin Field-Effect Transistor (signifiant transistor à effet de champ présentant une structure à nageoire), et dans les transistors de type FDSOI, acronyme du vocable anglais Fully Depleted Semiconductor on Insulator (signifiant semi-conducteur sur isolant totalement déserté).

En cas de sous-gravure (figure 1A), le pied d'espaceur 111 ne permet pas de former une jonction abrupte entre le canal du transistor et les régions source et/ou drain.

En cas de sur-gravure (figure 1B), la couche active endommagée 10R (par création de défauts cristallins, amorphisation, formation d'encoche ou « recess » 113 selon la terminologie anglo-saxonne) engendre des défauts dans le transistor et dégrade les performances de ce dernier. Notamment, l'endommagement de la couche active 10 peut nuire à la qualité de l'épitaxie qui sera effectuée à partir de cette couche active 10 pour former les zones de source et drain surélevés ou RSD (acronyme de « Raised Source/Drain »). Les performances du transistor en seront directement altérées. Typiquement, si l'épaisseur de la couche active endommagée 10R est inférieure à 4 nm (10⁻⁹ mètres) la croissance par épitaxie des RSD ne s'effectuera pas dans de bonnes conditions. Par ailleurs, l'endommagement de la couche active 10 peut augmenter les courants de fuite ce qui nuira également au fonctionnement du transistor et dégradera les performances de ce dernier.

Plusieurs solutions ont été proposées pour réduire les risques d'apparition de pieds ou d'endommagement de la couche sous-jacente.

Certaines solutions reposent sur l'amélioration des équipements de gravure de la couche de nitrure. Certaines de ces solutions se basent sur l'utilisation de gravures plasma au cours desquelles la température des électrons est réduite pour abaisser l'énergie des ions. Ces solutions présentent néanmoins pour inconvénient de réduire l'anisotropie de la gravure ce qui entraîne une dégradation du contrôle dimensionnel. Par ailleurs ces techniques ne sont pas compatibles avec les chimies polymérisantes puisque l'utilisation de plasmas à faibles énergies entraîne le dépôt de films minces sur les surfaces traitées. Par exemple l'utilisation de chimies, typiquement à base de CF₄/CH₄ permettent d'améliorer la sélectivité de la gravure du Si₃N₄ vis-à-vis du Si mais conduit à la formation de pieds importants.

Le document EP3174092A1 divulgue un procédé permettant d'améliorer le contrôle dimensionnel des espaceurs. Un autre type de solutions pour limiter l'apparition du recess et du pied d'espaceur est divulguée dans les documents FR3000601 A1 et FR3023971 A1.

Cette solution consiste à remplacer l'étape de gravure anisotrope par une étape d'implantation destinée à modifier les parties de la couche de nitrure de silicium à éliminer, suivie d'une étape de gravure sélective permettant d'éliminer seulement ces parties modifiées de la couche de nitrure de silicium.

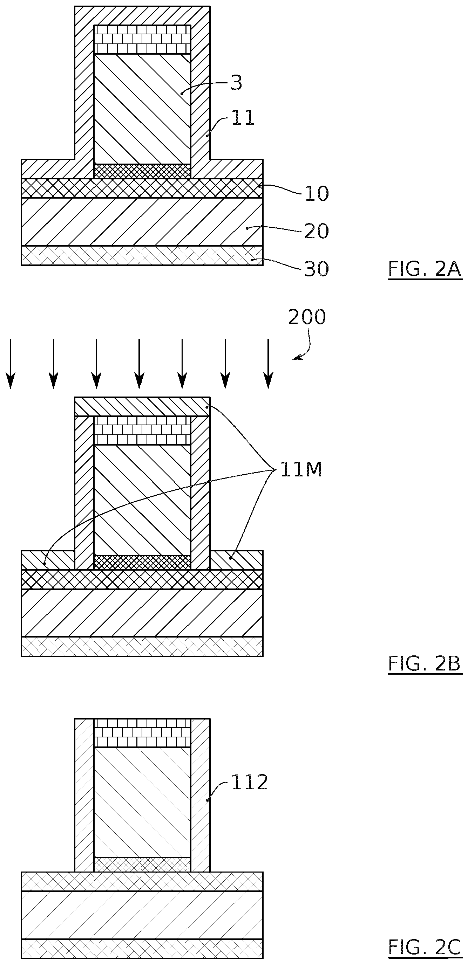

Ce procédé de formation d'espaceurs est illustré aux figures 2A à 2C :
- une couche 11 de nitrure de silicium est d'abord déposée de façon conforme sur la grille 3 et la couche active 10 (figure 2A),
- cette couche 11 de nitrure de silicium (SiN) est ensuite modifiée localement par implantation anisotrope 200 d'ions légers (H2, He) au niveau des parties 11M de la couche à éliminer (figure 2B), typiquement sur une épaisseur supérieure à 5 nm,
- ces parties modifiées 11M sont ensuite éliminées par gravure sélective du SiN modifié vis-à-vis du SiN non modifié (figure 2C).

Cette solution améliore la formation des espaceurs 112 en évitant la formation de pieds d'espaceurs tout en limitant l'apparition de recess, comparativement à une gravure anisotrope classique basée sur une chimie fluorocarbonnée.

Cependant, il s'avère en pratique que cette solution ne permet pas d'éviter totalement l'apparition du recess.

La présente invention vise à pallier certains des inconvénients mentionnés ci-dessus.

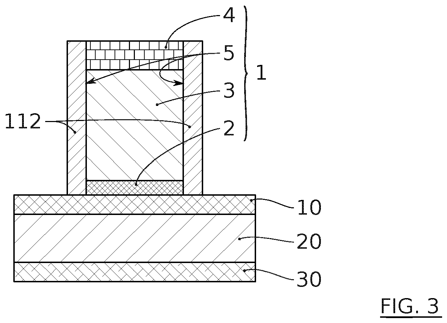

Il existe donc un besoin consistant à proposer une solution pour réduire, voire pour éliminer, au moins certains des inconvénients des solutions mentionnées ci-dessus. En particulier, il existe un besoin de formation d'espaceurs 112 présentant une épaisseur très bien contrôlée, sans pieds, et sans impact sur la couche active sous-jacente. Ce besoin est illustré à la figure 3. La dimension critique ou « CD » (pour « Critical Dimension) dépend notamment de l'uniformité et de la reproductibilité des espaceurs. Typiquement, pour la réalisation de transistors, la dimension critique peut-être ou peut dépendre à la largeur du motif de grille 1 incluant les espaceurs 112, cette largeur étant mesurée dans un plan parallèle au plan basal. L'absence de pieds d'espaceurs à la base du motif de grille 1 permet en particulier d'améliorer significativement ce CD. L'absence de recess ou de défauts dans la couche active 10 est un autre enjeu important lors de la formation des espaceurs 112.

La présente invention a notamment pour objet un procédé de formation d'espaceurs supprimant ou limitant l'apparition de recess dans la couche active, et supprimant ou limitant la formation de pieds au bas des flancs d'un motif de grille d'un transistor.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre les objectifs mentionnés ci-dessus, la présente invention prévoit selon un premier aspect un procédé de formation d'espaceurs sur un motif de grille de transistor comprenant les étapes successives suivantes :
- Fournir un empilement comprenant au moins une couche active s'étendant selon un plan basal et le motif de grille surmontant la couche active, le motif de grille présentant des flancs latéraux s'étendant selon des plans sensiblement perpendiculaires à la couche active,
- Déposer sur le motif de grille et la couche active une première couche en un premier matériau diélectrique présentant une épaisseur e1. La première couche comprend des premières portions latérales recouvrant les flancs latéraux du motif de grille. La première couche comprend également des premières portions basales, s'étendant parallèlement audit plan basal et recouvrant la couche active, les premières portions latérales étant sensiblement normales aux premières portions basales,
- Réaliser une modification anisotrope de ladite première couche selon une direction privilégiée parallèle aux flancs latéraux, de façon à obtenir des premières portions basales modifiées en conservant des premières portions latérales non modifiées,
- Effectuer au moins une séquence comprenant les étapes suivantes :
   ▪ Déposer sur ladite première couche une deuxième couche en un deuxième matériau diélectrique présentant une épaisseur e2 et comprenant des deuxièmes portions latérales recouvrant les premières portions latérales non modifiées, lesdites deuxièmes portions latérales étant directement au contact des premières portions latérales non modifiées, et des deuxièmes portions basales, s'étendant parallèlement au plan basal et recouvrant les premières portions basales modifiées,
   ▪ Réaliser une gravure anisotrope de ladite deuxième couche selon une direction privilégiée parallèle aux flancs latéraux, de façon à éliminer les deuxièmes portions basales en conservant une partie au moins des deuxièmes portions latérales non modifiées et en conservant une partie au moins de l'épaisseur e1 des premières portions basales modifiées,
- Retirer les premières portions basales modifiées qui sont mises à nu à l'issue de ladite gravure anisotrope de ladite deuxième couche en conservant les premières et deuxièmes portions latérales non modifiées pour former des espaceurs.

La présente invention fournit ainsi une solution permettant de former des espaceurs à base des premières et deuxièmes portions latérales non modifiées, présentant une épaisseur E = e1 + e2 sur les flancs latéraux du motif de grille. E se mesure à partir d'un flanc de la grille selon une direction parallèle au plan basal.

Cette épaisseur E est parfaitement contrôlée et constante le long des flancs latéraux. Avantageusement, les premières et deuxièmes portions latérales non modifiées soient conservées pour former les espaceurs. Cela améliore la précision sur le contrôle de l'épaisseur E et du CD. La formation des espaceurs se fait donc à partir d'au moins deux couches (les première et deuxième couches). Ainsi, selon cet exemple, les première et deuxième couches forment des espaceurs fonctionnels.

Les étapes de gravure anisotrope et de retrait sélectif permettent en outre d'éviter la formation de pieds d'espaceurs à la base du motif de grille.

La précision et l'uniformité du CD sont ainsi améliorées.

A l'issue du dépôt de la deuxième couche, une couche diélectrique d'épaisseur E comprenant les première et deuxième couches est formée.

Les portions basales de cette couche diélectrique (formées par les premières et deuxièmes portions basales) sont éliminées en deux étapes successives. Cela permet avantageusement de préserver la couche active.

La gravure anisotrope permet de retirer d'abord les deuxièmes portions basales sur une épaisseur de l'ordre de e2. Cette gravure anisotrope peut éventuellement impacter les premières portions basales sous-jacentes. En revanche, les premières portions basales d'épaisseur e1 permettent ainsi de protéger la couche active sous-jacente de cette gravure anisotrope, qui est une des causes de l'apparition du recess et/ou des défauts structuraux dans la couche active.

Les développements menés dans le cadre de la présente invention ont en effet permis d'identifier que :
- L'endommagement de la couche active est lié à une profondeur de gravure ou d'implantation trop importante.
- L'incertitude sur cette profondeur est d'autant plus grande que la couche diélectrique à implanter ou à graver est épaisse.

Ainsi les solutions connues basées sur la gravure anisotrope de la couche diélectrique d'épaisseur E conduisent à l'apparition d'un recess.

Les solutions connues basées sur une modification de la couche diélectrique par implantation d'ions hydrogène ou hélium sur toute son épaisseur E conduisent également à l'apparition d'un léger recess. Dans le cadre du développement de la présente invention, il a été identifié que cela est majoritairement dû à une énergie d'implantation importante qui augmente l'incertitude sur la profondeur d'implantation.

Au contraire, selon l'invention, seule l'épaisseur e1 est modifiée par implantation. Cette épaisseur e1 est strictement inférieure à l'épaisseur E de la couche diélectrique. L'énergie d'implantation peut ainsi être réduite par rapport à l'énergie d'implantation utilisée dans les solutions existantes.

L'incertitude sur la profondeur d'implantation est donc également réduite.

Il est ainsi possible d'implanter les premières portions basales d'épaisseur e1 sans impacter la couche active sous-jacente.

L'épaisseur e1 est de préférence faible, par exemple inférieure ou égale à 4 nm, et l'énergie d'implantation est de préférence limitée, par exemple inférieure à 30 eV, de préférence inférieure à 20 eV.

Par ailleurs, une modification par implantation de la première couche avant le dépôt de la deuxième couche permet d'éviter un cumul des incertitudes de profondeurs de gravure et d'implantation.

L'incertitude sur la profondeur d'implantation de la première couche d'épaisseur e1 est ainsi minimisée.

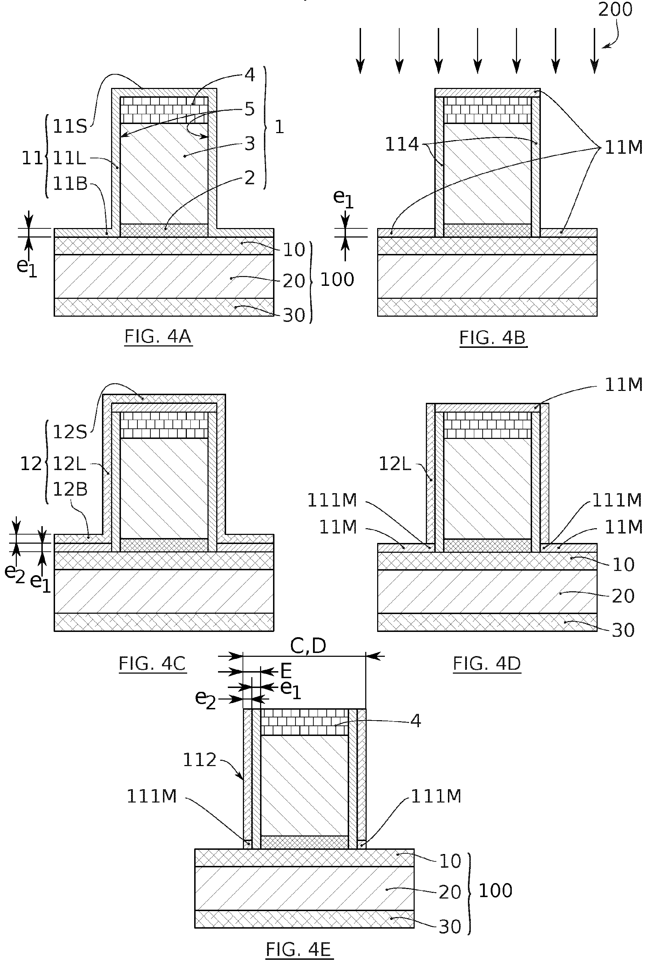

Le procédé selon l'invention permet avantageusement de former des espaceurs sans pieds, avec un très bon contrôle de CD, et sans endommager la couche active sous-jacente. Un exemple de CD est référencé en figure 4E. Dans cet exemple, le CD correspond à la largeur du motif de grille incluant les espaceurs.

Une solution alternative, qui diffère de la solution revendiquée mais qui aurait pu être envisagée dans le cadre du développement de la présente invention aurait consisté à :
- déposer une couche conforme de SiN dont l'épaisseur est suffisante pour former sur les flancs de la grille des espaceurs,
- graver d'abord partiellement des portions de la couche de SiN en dehors des flancs de façon à réduire leur épaisseur pour obtenir des portions résiduelles d'épaisseur environ égale à e1, puis à
- modifier ces portions résiduelles d'épaisseur e1, pour finalement les retirer de façon sélective.

Cette solution alternative n'a pas été retenue dans le cadre de la présente invention car il a été identifié que les portions résiduelles obtenues à l'issue de la gravure ne présentent pas une épaisseur constante et/ou homogène. Cette inhomogénéité d'épaisseur empêche le retrait complet de cette couche sans pour autant altérer la couche sous-jacente lors de la modification par implantation à travers cette couche d'épaisseur inhomogène. Cela conduit à l'apparition de recess après retrait sélectif des portions résiduelles modifiées.

La présente invention permet d'éviter ces inconvénients.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La FIGURE 1A illustre schématiquement en coupe un motif de grille flanqué d'espaceurs sur une couche active, les espaceurs présentant un pied selon l'art antérieur.
La FIGURE 1B illustre schématiquement en coupe un motif de grille flanqué d'espaceurs sur une couche active, la couche active présentant un recess selon l'art antérieur.
Les FIGURES 2A à 2C illustrent schématiquement des étapes d'un procédé de formation d'espaceurs selon l'art antérieur.
La FIGURE 2A illustre schématiquement une étape de dépôt d'une couche diélectrique sur un motif de grille selon ce procédé connu de formation d'espaceurs.
La FIGURE 2B illustre schématiquement une étape de modification de la couche diélectrique par implantation anisotrope selon ce procédé connu de formation d'espaceurs.
La FIGURE 2C illustre schématiquement une étape de retrait de la couche diélectrique modifiée selon ce procédé connu de formation d'espaceurs.
La FIGURE 3 illustre schématiquement un motif de grille flanqué d'espaceurs idéal répondant aux besoins des transistors actuels.
Les FIGURES 4A à 4E illustrent schématiquement des étapes d'un procédé de formation d'espaceurs selon un mode de réalisation de la présente invention.
La FIGURE 4A illustre schématiquement une étape de dépôt d'une première couche diélectrique sur un motif de grille selon un mode de réalisation de la présente invention.
La FIGURE 4B illustre schématiquement une étape de modification des portions basales de la première couche diélectrique par implantation anisotrope selon un mode de réalisation de la présente invention.
La FIGURE 4C illustre schématiquement une étape de dépôt d'une deuxième couche diélectrique sur la première couche diélectrique selon un mode de réalisation de la présente invention.
La FIGURE 4D illustre schématiquement une étape de gravure anisotrope des portions basales de la deuxième couche diélectrique selon un mode de réalisation de la présente invention.
La FIGURE 4E illustre schématiquement une étape de retrait des portions basales modifiées de la première couche diélectrique selon un mode de réalisation de la présente invention.

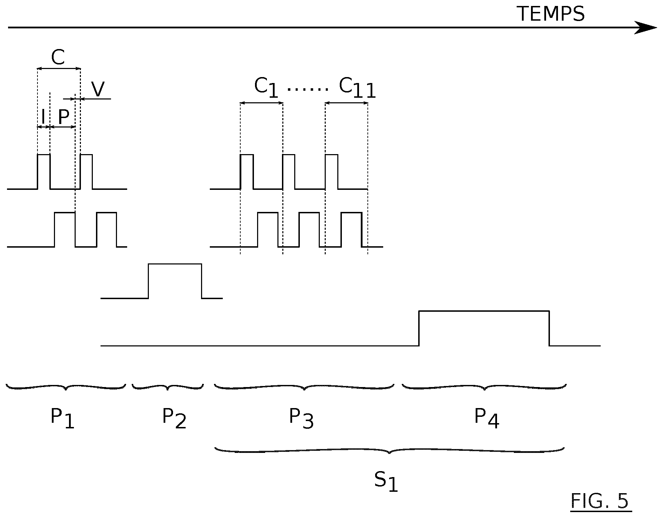

La FIGURE 5 illustre schématiquement la succession dans le temps des différentes phases de dépôts, d'implantation et de gravure du procédé de formation d'espaceurs selon un mode de réalisation de la présente invention.

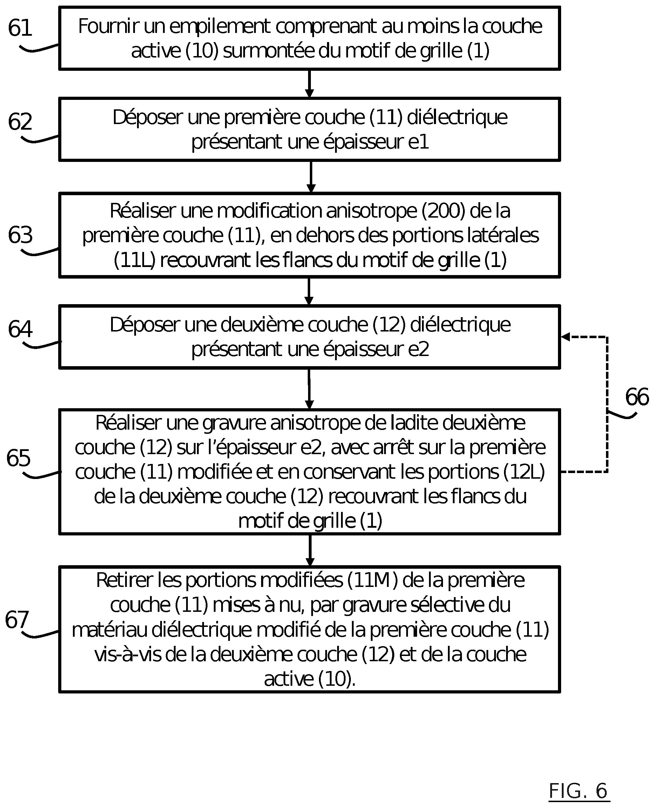

La FIGURE 6 résume certaines étapes du mode de réalisation illustré en figures 4A à 4E.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions des différentes couches et structures (espaceurs, motif de grille) ne sont pas représentatives de la réalité. Par souci de clarté des illustrations, l'épaisseur de la première couche est représentée de manière exagérément importante relativement à l'épaisseur de la deuxième couche.

### DESCRIPTION DÉTAILLÉE DE L'INVENTION

Avant d'entamer une revue détaillée de modes de réalisation de l'invention, il est rappelé que, de manière facultative, l'invention comprend au moins l'une quelconque des caractéristiques optionnelles suivantes qui peuvent être utilisées en association ou alternativement.

Selon un exemple, l'épaisseur e1 est inférieure à 4 nm. Cette épaisseur fine autorise l'utilisation de conditions d'implantation faibles en énergie et qui permettent de contrôler précisément la profondeur d'implantation. On évite ainsi d'implanter la couche sous-jacente tout en s'assurant que toute l'épaisseur e1 est modifiée par implantation. Selon un exemple, l'épaisseur e1 est inférieure ou égale à 2 nm (10⁻⁹ mètres).

Selon un exemple, les espaceurs présentent une épaisseur E = e1 + e2 avec E ≤ 30 nm, de préférence E ≤ 15 nm.

Selon un exemple, les premières portions basales modifiées présentent une épaisseur e1.

Selon un exemple, la modification anisotrope est effectuée en conservant les premières portions latérales non modifiées sur les flancs latéraux du motif de grille.

Selon un exemple, lors de l'étape de retrait des premières portions basales modifiées, on retire toutes les premières portions basales modifiées accessibles, en particulier toutes les portions premières portions basales modifiées accessibles à une solution de gravure humide. Les parties des premières portions basales modifiées qui sont surmontées par les deuxièmes portions latérales ne sont pas accessibles. En effet les deuxièmes portions latérales masquent et protègent ces parties des premières portions basales modifiées.

Selon un exemple, l'étape consistant à retirer les premières portions basales modifiées en conservant les premières et deuxièmes portions latérales non modifiées pour former des espaceurs est effectuée par une gravure sélective du premier matériau diélectrique modifié vis-à-vis du premier matériau diélectrique non modifié, du deuxième matériau diélectrique et du matériau de la couche active

Selon un exemple, la séquence d'étapes de dépôt et gravure anisotrope de la deuxième couche est réitérée au moins deux fois. Cette réitération de la séquence permet de contrôler avec une très bonne précision l'épaisseur déposée sur les flancs du motif de grille, tout en conservant la première couche qui fait office de protection pour la couche active sous-jacente.

Selon un exemple, ladite séquence est réitérée un nombre de fois permettant d'obtenir des espaceurs présentant une épaisseur E = e1 + e2 avec E ≤ 30 nm, de préférence E ≤ 15 nm. On peut ainsi obtenir des espaceurs relativement épais sur les flancs du motif de grille.

Selon un exemple, l'épaisseur e2 déposée au terme de chacune desdites séquences est comprise entre 2 et 5 nanomètres.

Selon un exemple, le dépôt de la première et/ou de la deuxième couches est un dépôt conforme, de sorte que les premières portions latérales et basales présentent sensiblement la même épaisseur e1, et/ou que les deuxièmes portions latérales et basales présentent sensiblement la même épaisseur e2.

Selon un exemple, le dépôt des première et deuxième couches se fait par un procédé de dépôt assisté par plasma. Il peut s'agir d'un dépôt de couches atomiques assisté par plasma PEALD (acronyme de « Plasma Enhanced Atomic Layer Déposition). Alternativement, il peut s'agir d'un dépôt en phase vapeur et chimique assisté par plasma PECVD (acronyme de plasma enhanced chemical vapor déposition). Ces procédés permettent de déposer avec précision des couches conformes d'épaisseur très faible.

Selon un exemple, la modification anisotrope se fait par implantation d'ions provenant d'un plasma selon une direction privilégiée parallèle aux flancs latéraux. Selon un exemple, les ions sont à base d'hydrogène ou d'hélium. Ce type d'implantation permet de modifier la couche implantée sans pour autant la pulvériser.

Selon un exemple, l'implantation est effectuée en utilisant une tension de polarisation inférieure à 30 V et une pression inférieure à 80 milli Torr.

Selon un exemple, la gravure anisotrope de la deuxième couche se fait par des ions provenant d'un plasma selon une direction privilégiée parallèle aux flancs latéraux, à partir d'au moins une espèce plus lourde que l'hélium et de préférence à partir d'argon (Ar).

Selon un exemple, l'au moins une espèce n'est pas du type CₓH_{y} où x est la proportion de carbone (C) et y est la proportion d'hydrogène (H). Ainsi, selon cet exemple, la première couche n'est pas recouverte par un film carboné. Plus précisément, les premières portions latérales 11L ne sont pas au contact d'un film carboné.

Selon un exemple, la gravure selon la direction normale au plan basal se fait pour une tension de polarisation inférieure à 30 V et pour une pression inférieure à 80 milli Torr, de préférence inférieure à 10 milli Torr.

Selon un exemple, le ou les matériaux diélectriques sont choisis parmi le SiN, le SiCO, le SiC, le SiCN, le SiOCN, le SiCBN, le SiOCH, et le SiO2.

Selon un exemple, le ou les matériaux diélectriques présentent une constante diélectrique inférieure ou égale à 7.

Selon un exemple, le premier matériau diélectrique et le deuxième matériau diélectrique sont identiques. Cela permet d'obtenir des espaceurs homogène sur les flancs du motif de grille.

Selon un exemple, le dépôt des première et deuxième couches et la modification anisotrope sont effectuées au sein d'un même réacteur. Cela permet d'éviter les oxydations involontaires, de réduire le nombre d'étapes et la complexité du procédé. Le coût de fabrication s'en trouve également amoindri.

Selon un exemple, la gravure sélective du premier matériau diélectrique modifié est une gravure humide à l'aide d'une solution à base d'acide fluorhydrique (HF).

Selon un exemple, la solution à base d'acide fluorhydrique (HF) présente une dilution en HF comprise entre 0.1% et 5% en masse.

Sauf mention explicite, il est précisé que, dans le cadre de la présente invention, la disposition relative d'une troisième couche intercalée entre une première couche et une deuxième couche, ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

Les étapes de formation des différentes couches s'entendent au sens large : elles peuvent être réalisées en plusieurs sous-étapes (en particulier cycles de d'adsorption de précurseurs et purge dans le cas d'un dépôt de couches minces atomiques).

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, une couche diélectrique à base de nitrure de silicium SiN peut par exemple comprendre du nitrure de silicium non stoechiométrique (SiN), ou du nitrure de silicium stoechiométrique (Si₃N₄), ou encore un oxy-nitrure de silicium (SiON).

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7.

Les matériaux diélectriques envisagés dans le cadre la présente invention sont, de manière non limitative, le SiN, le SiCO, le SiC, le SiCN, le SiOCN, le SiBCN, le SiOCH, le SiO2.

Le matériau diélectrique modifié est réputé différent du matériau diélectrique non modifié.

Les termes « matériau diélectrique », « matériau diélectrique initial », « matériau diélectrique non modifié » sont synonymes.

Les termes « motif de grille », «empilement de grille », « grille » sont employés en synonymes.

Dans la présente demande de brevet, on parlera préférentiellement d'épaisseur pour une couche et de hauteur pour un dispositif (transistor ou grille par exemple). La hauteur est prise selon une direction normale au plan basal. L'épaisseur en un point de la couche est prise selon une direction normale à la tangente à la couche en ce point. Ainsi, sur les figures, l'épaisseur est prise selon la verticale dans les zones qui s'étendent principalement à l'horizontale, telles que les portions basales. En revanche, l'épaisseur est prise selon l'horizontale dans les zones qui s'étendent principalement à la verticale, telles que les portions latérales. Ainsi, l'épaisseur des espaceurs qui recouvrent des flancs verticaux d'une grille ou d'un motif de grille sera mesurée selon la direction horizontale sur les figures.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

Pour déterminer la géométrie des espaceurs et la disposition des différentes couches, on peut procéder à des analyses de microscopie électronique, en particulier de Microscopie Electronique à Balayage (MEB) ou de Microscopie Electronique en Transmission (MET ou TEM).

Les compositions chimiques des différentes couches ou régions peuvent être déterminées à l'aide de la méthode bien connue EDX ou X-EDS, acronyme de « energy dispersive x-ray spectroscopy » qui signifie « analyse dispersive en énergie de photons X ».

Cette méthode est bien adaptée pour analyser la composition de couches de faibles épaisseurs telles que la couche active et les espaceurs. Elle peut être mise en oeuvre sur des coupes métallurgiques au sein d'un MEB ou d'un MET.

Ces techniques permettent notamment de déterminer si les espaceurs présentent un pied, s'il y a des résidus de couche diélectrique sur la couche active, s'il y a des défauts structuraux ou du recess dans la couche active.

En mettant en oeuvre le procédé selon l'invention, des espaceurs sont formés sans pied ou avec un pied de taille réduite, les résidus de couche diélectrique sont réduits voire éliminés, et la couche active est préservée des défauts structuraux ou du recess.

Un mode de réalisation du procédé de formation d'espaceurs selon l'invention va maintenant être décrit en référence aux figures 4A à 4E et à la figure 6.

Selon ce mode de réalisation, un empilement de grille ou motif de grille 1 reposant sur un substrat 100 est fourni.

Le substrat 100 peut être un substrat élaboré de type semi-conducteur sur isolant, par exemple un substrat silicium sur isolant SOI (acronyme de l'anglais « silicon on insulator) ou un substrat germanium sur isolant GeOI (acronyme de l'anglais « germanium on insulator) ou encore un substrat silicium-germanium (SiGe) sur isolant.

Ce substrat 100 peut typiquement comprendre un support massif 30 en silicium, une couche d'oxyde enterrée 20 également dénommée BOX (« Burried OXide ») et une couche active 10 semiconductrice à base de silicium ou de germanium.

La couche active 10 est de préférence en silicium (Si) ou en silicium-germanium (SiGe).

La couche active 10 est surmontée d'un empilement de grille ou motif de grille 1. De manière classique, l'empilement de grille peut comprendre une succession de couches disposées à partir de la couche active 10, telles que, par exemple :
- une couche à haute constante diélectrique 2, dite couche « high k »,
- une grille 3 métallique, par exemple en silicium polycristallin,
- une couche 4 formant un masque dur au sommet de la grille 3.

L'empilement de grille présente typiquement une hauteur de plusieurs dizaines de nanomètres à plusieurs centaines de nanomètres.

Dans la suite de la description, cet empilement sera désigné motif de grille 1 ou HKMG (acronyme de « High K Metal Grid »).

L'étape référencée 61 sur la figure 6 correspond à la fourniture d'un tel empilement.

Tel qu'illustré à la figure 4A, une première couche 11 en un matériau diélectrique est déposée sur le motif de grille 1 et sur la couche active 10 semi conductrice, de préférence de façon conforme. Ce dépôt correspond à l'étape référencée 62 sur la figure 6.

Le dépôt du matériau diélectrique est de préférence effectué par un premier dépôt assisté par plasma. Il peut s'agir d'un dépôt de couches atomiques assisté par plasma PEALD (acronyme de « Plasma Enhanced Atomic Layer Déposition). Alternativement, il peut s'agir d'un dépôt chimique en phase vapeur assisté par plasma PECVD (acronyme de plasma enhanced chemical vapor déposition). Ces types de dépôts permettent d'obtenir une couche dont l'épaisseur est fine, parfaitement contrôlée et présentant un profil conforme. Ainsi, l'épaisseur de la première couche 11 est homogène sur toute la surface du substrat et du motif de grille 1. Ces types de dépôts permettent également d'obtenir un matériau dense, stoechiométrique (par exemple Si₃N₄), encapsulant uniformément le motif de grille 1.

En outre ces types de dépôts assistés par plasma permettent de limiter la température de dépôt de façon à préserver le motif de grille 1, notamment l'empilement HKMG.

Cette première couche 11 comprend des premières portions latérales 11L sur chacun des flancs latéraux du motif de grille 1, des premières portions basales 11B en surface et au contact de la couche active 10 de part et d'autre du motif de grille 1, et une première portion sommitale 11S au sommet du motif de grille 1. Les premières portions latérales 11L s'étendent selon des plans perpendiculaires au plan basal et les premières portions basales 11B s'étendent selon des plans parallèles au plan basal.

De préférence, la première couche 11 est déposée directement au contact de la couche active 10. De préférence également, la première couche 11 est déposée directement au contact des flancs du motif de grille 1.

La première couche 11 présente une épaisseur e1 comprise entre 1 nm et 4 nm, de préférence entre 1 nm et 3 nm et encore plus préférentiellement entre 1 nm et 2 nm.

Comme illustré à la figure 4B, une première étape de modification anisotrope de la première couche 11 est effectuée. Cette modification correspond à l'étape 63 de la figure 6. Cette modification anisotrope 200 est configurée pour modifier le matériau diélectrique initial.

Elle peut notamment être réalisée par implantation d'espèces, en particulier des ions, au niveau des portions de la couche 11 s'étendant principalement selon le plan basal. Cette implantation anisotrope est effectuée selon une direction principale de bombardement des ions. Cette direction principale est donc parallèle aux flancs latéraux du motif de grille 1.

La modification anisotrope 200 est configurée pour modifier le matériau diélectrique des premières portions basales 11B sur toute leur épaisseur e1, et de la première portion sommitale 11S éventuellement sur toute son épaisseur e1.

Les premières portions basales et sommitale 11B, 11S deviennent ainsi des premières portions modifiées 11M.

Les premières portions latérales 11L sont avantageusement non modifiées à l'issue de cette étape de modification anisotrope. En effet, ces premières portions latérales 11L s'étendent dans des plans parallèles à la direction privilégiée d'implantation.

Les paramètres de l'implantation, en particulier la nature des espèces implantées ainsi que leur concentration, sont configurés de sorte à ce que les portions modifiées 11M présenteront une vitesse de gravure supérieure aux portions non modifiées 11L lors d'une étape de gravure ultérieure, comme cela sera expliqué en détail par la suite.

Comme cela sera décrit par la suite dans la section « modification anisotrope », on privilégie une modification par implantation d'ions légers à partir d'un plasma.

Cette implantation est effectuée de manière à modifier la structure de la première couche 11 dans les zones implantées, sans entraîner de pulvérisation de cette couche. Avantageusement, l'implantation est effectuée de manière à ce que les ions implantés soient répartis de manière ininterrompue depuis la surface de la première couche 11 jusqu'à l'interface entre cette première couche 11 et la couche qui lui est sous-jacente typiquement la couche active 10. Cette répartition ne présente pas de discontinuité. Il n'y a donc pas de strates où les espèces implantées sont absentes au sein de la première couche 11.

Une implantation par plasma a pour avantage de permettre une implantation de manière continue dans un volume s'étendant dès la surface de la couche implantée. Cette continuité d'implantation permet d'améliorer l'homogénéité de la modification, ce qui conduit ensuite à une gravure de la couche implantée à une vitesse de gravure constante le long de toute l'épaisseur de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

Par ailleurs, de manière particulièrement avantageuse puisque l'épaisseur e1 est faible, il est alors possible d'implanter toute cette épaisseur avec des ions présentant une énergie faible. Dès lors, il est possible de contrôler à la fois que la première couche est effectivement implantée sur toute son épaisseur e1 et à la fois que les ions implantés n'atteignent pas la couche active 10 sous-jacente. Ainsi, contrairement à des solutions existantes qui prévoient l'implantation d'une couche plus épaisse, la couche active 10 n'est pas altérée par cette étape de modification par implantation.

Comme illustré à la figure 4C, une deuxième couche 12 en un matériau diélectrique est déposée sur la première couche 11 et directement au contact de la première couche 11. Ce dépôt correspond à l'étape référencée 64 sur la figure 6. De préférence ce dépôt est effectué de façon conforme. Le matériau diélectrique de la deuxième couche 12 est de préférence le même que celui de la première couche 11. Selon un mode de réalisation alternatif, le matériau diélectrique de la première couche 11, désigné premier matériau diélectrique est différent du matériau diélectrique de la deuxième couche 12, désigné deuxième matériau diélectrique.

Ce deuxième dépôt est de préférence assisté par plasma. Il s'agit de préférence d'un dépôt PEALD ou PECVD.

Les premier et deuxième dépôts conformes sont illustrés et décrits plus en détail dans la suite, dans la section « dépôts conformes des première et deuxième couches ».

La deuxième couche 12 présente une épaisseur e2. Avantageusement, e2 est supérieure ou égale à e1. De préférence e1<0,5*e2. De préférence, e2 est comprise entre 5 nm et 30 nm, de préférence entre 8 nm et 15 nm. Cela permet d'épaissir l'espaceur formé sur les flancs 5 du motif de grille 1 de manière rapide. Selon un mode de réalisation alternatif, on peut avoir e2 inférieure ou égale à e1.

Cette deuxième couche 12 comprend des deuxièmes portions latérales 12L sur chacun des flancs latéraux du motif de grille 1, au contact des premières portions latérales 11L. Ainsi selon cet exemple, il n'y a pas une autre couche, par exemple une couche carbonée, située entre les deuxièmes portions latérales 12L et les premières portions latérales 11L.

La deuxième couche 12 comprend également des deuxièmes portions basales 12B en surface et au contact des premières portions basales 11B modifiées, de part et d'autre du motif de grille 1.

La deuxième couche 12 comprend également une deuxième portion sommitale 12S au sommet du motif de grille 1, sur la première portion sommitale 11S modifiée.

Les deuxièmes portions latérales 12L s'étendent selon des plans perpendiculaires au plan basal et les deuxièmes portions basales 12B s'étendent selon des plans parallèles au plan basal.

Comme illustré à la figure 4D, une étape de gravure anisotrope de la deuxième couche 12 est effectuée. Cette étape de gravure est référencée 64 sur la figure 6. La direction privilégiée de cette gravure anisotrope est sensiblement parallèle aux plans dans lesquels s'étendent les flancs du motif de grille 1. Ainsi, cette gravure anisotrope est configurée pour retirer les deuxièmes portions basales 12B et la deuxième portion sommitale 12S. En revanche, les deuxièmes portions latérales 12L situées sur les flancs du motif de grille 1 sont avantageusement préservées à l'issue de cette étape de gravure anisotrope ou sont consommées sur une épaisseur bien moindre.

Différentes solutions de gravure adaptées à cette étape de gravure anisotrope sont détaillées dans la suite, dans la section « gravure anisotrope ».

La gravure anisotrope est effectuée de sorte à exposer les premières portions modifiées 11M. De préférence, la gravure anisotrope est stoppée de manière à consommer toute l'épaisseur e2 de la deuxième couche 12 des portions 12B en s'arrêtant à l'interface entre ces portions 12B et les portions 11M. Ainsi, l'épaisseur e1 n'est pas consommée. L'arrêt de cette gravure est contrôlé au temps. On peut néanmoins prévoir que cette gravure anisotrope consomme une partie de l'épaisseur e1, tant que les portions 11M continuent de former une couche de protection qui protège la couche active 10 lors de cette étape de gravure anisotrope.

Ainsi, à l'issue de la gravure anisotrope des portions 12S et 12B de la deuxième couche 12 :
- on conserve tout ou partie de l'épaisseur des portions 12L de la deuxième couche 12 situées sur les flancs du motif 1 de grille. On forme ainsi sur ces flancs un espaceur 112.
- on fait en sorte de conserver toute l'épaisseur, ou au moins une partie de l'épaisseur des premières portions modifiées 11M. Ces portions modifiées 11M recouvrent ainsi la couche active 10 et agissent sur cette dernière comme une couche de protection ou de masquage durant la gravure anisotrope de la deuxième couche 12. Grâce à la présence des portions modifiées 11M de la première couche 11, la couche active 10 n'est ainsi pas endommagée lors de la gravure anisotrope des portions 12S et 12B.

Sur l'exemple illustré aux figures 4A à 4E, on effectue une seule séquence comprenant l'étape de dépôt de la deuxième couche 12 et la gravure anisotrope des portions 12S et 12B. Selon un autre mode de réalisation, on effectue successivement une pluralité de séquences comprenant chacune ces deux étapes. Ainsi, à chaque séquence on augmente l'épaisseur des portions 12L recouvrant les flancs du motif 1 de grille. Cela permet d'obtenir sur les flancs du motif 1 de grille des espaceurs 112 présentant une épaisseur importante sans pour autant devoir graver une épaisseur importante pour les portions 12S et 12B. Lors de cette gravure il est alors possible d'utiliser des conditions de gravure moins agressives et donc plus précises. La flèche 66 en figure 6 illustre ce mode de réalisation facultatif consistant à effectuer plusieurs séquences d'étapes de dépôt et de gravure anisotrope de la deuxième couche 12.

De façon particulièrement avantageuse, les premier et deuxième dépôts, la modification anisotrope et la gravure anisotrope sont effectués au sein d'un même réacteur. Cela permet d'éviter toute oxydation parasite des différentes couches et portions entre chaque étape. Le contrôle du CD et de la morphologie des couches est optimisé. Cela permet également de simplifier le procédé et de réduire les couts.

A l'issue de la gravure anisotrope, une étape de retrait des premières portions modifiées 11M est effectuée, tel qu'illustré à la figure 4E. Cette étape est référencée 67 en figure 6.

Cette étape de retrait est configurée pour retirer le matériau diélectrique modifié accessible, c'est-à-dire mis à nu, sélectivement au matériau diélectrique non modifié situé sur les flancs 5 du motif de grille 1 et au matériau semiconducteur de la couche active 10. Pour cela, on utilise une chimie de gravure permettant de graver le matériau diélectrique modifié sélectivement au matériau diélectrique non modifié et au matériau semi-conducteur de la couche active 10. On notera que les parties 111M de matériau diélectrique modifié situées à l'aplomb des portions latérales 12L ne sont pas accessibles, par exemple par une solution de gravure humide. Ces parties 111M sont en effet masquées et donc protégées par les portions latérales 12L lors de cette étape de retrait. Par ailleurs, cette étape de retrait est contrôlée de sorte à être interrompue avant que ces parties 111M ne soient attaquées latéralement, c'est-à-dire selon une direction parallèle à la face supérieure du substrat 100.

Les deuxièmes portions latérales 12L et la couche active 10 sont ainsi préservées.

Différents modes de réalisation de l'étape de retrait sont décrits en détail dans la suite, dans la section « retrait sélectif ».

A l'issue de cette étape de retrait, les espaceurs 112 sont formés. Ces espaceurs 112 comprennent les parties 111M de matériau diélectrique modifié qui sont restées en place à l'issue de l'étape de retrait.

Ces espaceurs 112 comprennent les première et deuxième portions latérales 11L, 12L. Ils présentent ainsi une épaisseur E = e1 + e2 uniforme et parfaitement contrôlée.

Différents modes de réalisation des étapes mentionnées ci-dessus vont maintenant être décrits en détail.

La figure 5 illustre sur une même échelle de temps la succession des différentes phases P1, P2, P3, P4 de dépôts conformes (P1 et P3), de modification anisotrope (P2), et de gravure anisotrope (P4) au sein d'un même réacteur. Ces différentes phases vont être détaillées par la suite.

### Dépôts conformes des première et deuxième couches

La figure 5 illustre une phase P1 correspondant au dépôt conforme de la première couche 11, et une phase ultérieure P3 correspondant au dépôt conforme de la deuxième couche 12.

Les dépôts des première 11 et deuxième 12 couches comprennent typiquement une pluralité de cycles successifs destinés à former une pluralité de couches atomiques superposées. Les première 11 et deuxième 12 couches sont ainsi formées par superposition de couches atomiques de matériau diélectrique. Cela permet de contrôler avec précision les épaisseurs de ces couches 11, 12.

Tel qu'illustré à la figure 5, chaque cycle C comprend typiquement une injection I d'un précurseur gazeux au sein du réacteur. Ce précurseur est alors dissocié à l'aide d'un plasma P. Des espèces réactives sont ainsi formées puis adsorbées sur les surfaces de dépôt.

Cette adsorption permet de former une couche atomique du matériau diélectrique sur les surfaces de dépôt.

L'excédent de précurseur et/ou d'espèces réactives est ensuite évacué par une purge V du réacteur en fin de cycle C.

Les précurseurs gazeux et le plasma utilisés dépendent du matériau diélectrique à déposer.

Le nombre de cycles réalisés détermine le nombre de couches atomiques déposées et, de fait, l'épaisseur totale de la couche diélectrique formée.

Pour former une couche en nitrure de silicium SiN, un précurseur à base de silicium combiné à un plasma à base d'azote peuvent être utilisés. Pour former ce plasma à base d'azote on peut par exemple injecter dans le réacteur du N₂ ou du NH₃.

Un précurseur dichlorosilane (DCS) combiné à un plasma d'ammoniac peut aussi être utilisé. La température de dépôt est typiquement comprise entre 500 °C et 650 °C. Cette gamme de températures de dépôt permet d'améliorer la qualité de la couche de SiN obtenue.

Un précurseur de type Di(Sec-ButylAmino)Silane (DSBAS, SiH₃N(ₛBu)₂) peut être préférentiellement utilisé, combiné à un plasma d'ammoniac ou d'azote. Ce type de précurseur a pour avantage d'avoir un seul groupement amino et permet l'obtention de films de très bonne qualité, en particulier lorsqu'il est combiné à un plasma de N2 et que la température de dépôt est de l'ordre de 400°C. En particulier, ce type de dépôts présente une très bonne densité, une très faible contamination et une vitesse de gravure humide faible (habituellement désignée par l'acronyme WER du vocable anglais wet-etch rates).

Pour former une couche en SiBCN, du trichlorure de bore BCl3 et du méthane peuvent par exemple être ajoutés au DCS.

De préférence, le substrat et/ou les surfaces de dépôt ne sont pas polarisés de façon à obtenir un dépôt conforme. Autrement dit, la tension de polarisation est nulle ou très faible.

De préférence, un cycle de dépôt C correspond à la formation d'une couche présentant une épaisseur de l'ordre de 0,1Å à 0,2Å. De préférence, un cycle de dépôt C correspond à la formation d'une unique couche atomique.

Par exemple, 80 cycles successifs C1-Cn (n=80) permettent de former une couche diélectrique de 12 nm environ (figure 5).

Le nombre de cycles est ainsi adapté à l'épaisseur de couche souhaitée.

Selon une possibilité avantageuse, l'épaisseur des dépôts est contrôlée in situ par ellipsométrie, cycle après cycle.

### Modification anisotrope 200

La modification anisotrope de la première couche 11 est avantageusement effectuée au sein du même réacteur, après le dépôt de la première couche 11 de 1 nm à 2 nm d'épaisseur. Comme mentionné ci-dessus, cette étape permet de modifier les premières portions basales et sommitale 11B, 11S sur toute l'épaisseur e1 de la première couche 11.

En revanche, cette modification ne modifie pas les premières portions latérales 11L situées sur les flancs du motif de grille 1.

Cette modification anisotrope 200 est effectuée par implantation d'ions légers à partir d'un plasma. Comme indiqué ci-dessus, une implantation à partir d'un plasma présente de nombreux avantages puisqu'elle permet d'implanter de manière très précise toute l'épaisseur de la première couche 11 qui est mince, sans pour autant modifier la couche qui lui est sous-jacente, typiquement la couche active 10.

Si l'on souhaite utiliser le même réacteur de gravure pour l'étape de dépôt de la première couche 11 et pour l'étape de modification anisotrope 200, il est préférable d'utiliser un réacteur plasma permettant d'effectuer un dépôt conforme typiquement un réacteur PEALD ou PECVD.

Le plasma peut être à base d'hydrogène (H). Selon un exemple de réalisation, cette modification comprend l'implantation d'ions à base d'hydrogène (H, H+, H2+, H3+, etc....). Selon un autre mode de réalisation les ions implantés sont des ions d'hélium (He) ou un mélange d'ions d'hélium et d'hydrogène (H/He).

Ces ions peuvent provenir par exemple des gaz suivants introduits dans le réacteur : H2, HBr ; NH3.

Pour obtenir une bonne sélectivité lors de l'étape de retrait des portions modifiées 11M, on règle l'implantation de sorte à ce que la concentration en ions légers dans la première couche 11 implantée soit idéalement comprise entre 1. 10¹² - 10.10¹² ions/cm³.

Afin d'obtenir une implantation précise sur toute l'épaisseur e1, et en particulier pour stopper cette implantation à l'interface entre la première couche 11 diélectrique et la couche active 10, parmi les paramètres retenus pour le plasma, on prévoit que la tension de polarisation (bias) soit suffisamment faible pour éviter un endommagement de la couche active 10 sous-jacente. De préférence cette tension de polarisation est inférieure à 30V. En effet, le procédé décrit ci-dessus prévoit une épaisseur e1 faible pour la première couche 11. Il est alors possible d'utiliser une tension de polarisation réduite qui permet de contrôler parfaitement la profondeur à laquelle les ions sont implantés. Contrairement à des procédés connus visant à modifier des couches d'épaisseurs plus épaisses, typiquement supérieure à 8 nm, le procédé revendiqué permet d'éviter que des ions implantés parviennent jusque dans la couche active 10. Cette couche active 10 n'est alors pas altérée. De préférence, la tension de polarisation est supérieure à 10V, de manière à accélérer et à diriger les ions selon une direction normale au substrat.

Par ailleurs, afin d'améliorer la précision de l'implantation sur toute l'épaisseur e1 en évitant que la couche active 10 soit altérée, on peut également utiliser au moins l'un des paramètres de plasma suivants:
- La pression au sein du réacteur est inférieure à 100 milli Torr, et de préférence inférieure à 30 milli Torr. La pression est préférentiellement de l'ordre de 10 milli Torr. Cela permet d'avoir des ions principalement dirigés selon une direction normale au substrat 100. Les portions latérales 11L sont ainsi préservées de cette implantation. (On rappelle que 1 Torr est égal à 133,32 Pa).
- La température appliquée au substrat est de préférence inférieure à 100°C. Cela permet d'éviter une désorption des ions hydrogène implantés. La modification des portions 11B, 11S de la première couche 11 diélectrique est ainsi plus efficace.

Ces conditions d'implantation sont par exemple déterminées par simulation en utilisant des outils de simulation de type SRIM (stopping and range of ions matter) ou TRIM (transport simulation of ions in matter).

Une phase P2 d'implantation d'ions légers est illustrée à la figure 5, après la phase P1 de dépôt de la première couche 11.

### Gravure anisotrope

Comme mentionné ci-dessus, la gravure anisotrope permet de graver les deuxièmes portions basales et sommitale 12B, 12S sur toute l'épaisseur e2.

En revanche, les deuxièmes portions latérales 12L sont préservées lors de cette gravure.

La gravure anisotrope est de préférence effectuée au sein du même réacteur, après le dépôt de la deuxième couche 12 de 8 nm à 15 nm d'épaisseur.

Cette gravure anisotrope est effectuée par bombardement d'ions à partir d'un plasma.

Comme pour l'étape de modification par implantation, le plasma utilisé pour l'étape de gravure anisotrope peut être à couplage capacitif (CCP) ou à couplage inductif (ICP).

Le plasma peut être à base d'espèces plus lourdes que l'hydrogène et de préférence plus lourde que l'hélium. Les paramètres utilisés pour cette gravure peuvent conduire à ce que le bombardement de ces espèces sur la deuxième couche 12 conduise à son retrait par pulvérisation. À cet effet, on peut utiliser des ions lourds tels que l'argon (Ar).

Afin d'obtenir une gravure anisotrope, au moins l'un des paramètres de plasma suivants sont de préférence utilisés :
- La pression au sein du réacteur est inférieure à 80 milli Torr, et de préférence de l'ordre de 10 milli Torr. Cela permet d'avoir des ions principalement dirigés selon une direction normale au substrat. Les portions latérales 12L sont ainsi préservées lors de cette gravure.
- La tension de polarisation est de préférence supérieure à 10V, de manière à accélérer et diriger les ions selon une direction normale au substrat. Elle est inférieure à 100V, et de préférence inférieure à 30V, de manière à éviter un endommagement des couches sous-jacentes, en particulier de la couche active 10.

Ces conditions d'implantation sont par exemple déterminées par simulation en utilisant des outils de simulation de type SRIM (stopping and range of ions matter) ou TRIM (transport simulation of ions in matter).

Une phase P4 de gravure anisotrope est illustrée à la figure 5, après la phase P3 de dépôt de la deuxième couche 12.

La phase P3 et la phase P4 constituent une séquence, notée S1 en figure 5. Cette séquence permet de laisser en place une épaisseur e2 de couche diélectrique sur les flancs du motif de grille 1.

Cette séquence S1 peut être effectuée une seule fois où une pluralité de fois. Par exemple, les étapes de deuxième dépôt conforme et de gravure anisotrope peuvent être répétées X fois de façon à obtenir des deuxièmes portions latérales 12L présentant l'épaisseur X.e2. Les espaceurs 112 peuvent dès lors présenter une épaisseur E = e1 + X.e2, en fonction des besoins.

### Retrait sélectif

Plusieurs variantes de réalisation pour le retrait sélectif des premières portions 11M modifiées de la première couche 11 diélectrique sont possibles.

Des chimies de gravure sèches ou humides peuvent être utilisées.

Selon un mode de réalisation, l'étape de retrait des premières portions 11M modifiées est effectuée par gravure humide sélective vis-à-vis du matériau semi-conducteur de la couche active 10 et du matériau diélectrique non modifié des espaceurs 112. Une telle gravure humide sélective peut se faire à l'aide d'une solution à base d'acide fluorhydrique (HF). Dans ce cas, on peut utiliser une solution à base d'acide fluorhydrique (HF) présentant une dilution en HF comprise entre 0.1% et 5% en masse.

De préférence, la gravure sélective est obtenue à l'aide d'une solution à base d'acide fluorhydrique (HF). Une telle solution est sélective vis-à-vis du silicium (Si), du silicium-germanium (SiGe), et du nitrure de silicium (SiN).

A titre d'exemple pour une première couche 11 diélectrique en SiN, avec une solution à base d'acide fluorhydrique (HF), le rapport de vitesse de gravure entre SiN modifié et SiN est de l'ordre de 30.

Cela permet de retirer entièrement les premières portions 11M modifiées sans consommer les premières et deuxièmes portions latérales 11L, 12L non modifiées sur les flancs 24 du motif de grille 1, et sans consommer la couche active 10.

Lorsque le matériau diélectrique est pris parmi : un nitrure de silicium, SiC, SiCN, SiCBN, le retrait sélectif des premières portions 11M modifiées vis-à-vis des premières et deuxièmes portions latérales 11L, 12L non modifiées comprend de préférence une gravure humide à base d'une solution comprenant de l'acide fluorhydrique (HF) diluée à x% en masse, avec 0.1≤x≤5.

Selon une possibilité avantageuse, cette solution présente en outre un pH inférieur ou égal à 1.5, et de préférence strictement inférieur à 1.

De manière surprenante une telle solution de gravure permet d'augmenter très significativement la sélectivité S_{11M:SiO2} de la gravure de la couche diélectrique modifiée vis-à-vis des matériaux à base d'oxyde de silicium (SiO2).

Par exemple, une sélectivité S_{11M:SiO2} ≈ 33:1 peut être obtenue.

Cette sélectivité améliorée permet notamment de préserver le masque dur 4 en SiO2 au sommet du motif de grille 1.

Selon un autre mode de réalisation, l'étape de retrait sélectif est effectuée par gravure sèche.

Une telle gravure sèche peut se faire par plasma à base de trifluorure d'azote (NF3) et/ou d'ammoniac (NH3).

La gravure sèche peut comprendre une étape de transformation des premières portions 11M modifiées en sels solides, suivie par une étape de sublimation de ces sels solides. Ce mode de réalisation permet d'obtenir une très bonne sélectivité de la gravure du nitrure modifié par rapport au nitrure non modifié et au matériau semi-conducteur. Cette sélectivité peut être supérieure à celle obtenue avec une solution de HF.

Avantageusement, la gravure sèche consomme les premières portions 11M modifiées de la première couche 11 diélectrique préférentiellement aux premières et deuxièmes portions latérales 11L, 12L non modifiées et à la couche active 10. Le risque de consommation excessive de matériau semi-conducteur en surface de la couche active 10 est ainsi réduit, voire supprimé.

Au regard de la description ci-dessus, il apparaît clairement que le procédé revendiqué propose une solution simple à mettre en oeuvre et particulièrement efficace pour améliorer le contrôle dimensionnel des espaceurs tout en réduisant les risques d'apparition de pieds ou de recess à la base du motif de grille.

L'invention n'est pas limitée aux modes de réalisations précédemment décrits et s'étend à tous les modes de réalisation couverts par les revendications. Dans les modes de réalisation illustrés, le motif de grille 1 est réalisé préalablement aux étapes de l'invention. Ces figures illustrent ainsi un procédé de type « gate first ».

Selon un autre mode de réalisation couvert par les revendications, l'empilement fonctionnel de grille est réalisé postérieurement aux étapes de l'invention. Un motif sacrificiel est dès lors utilisé à la place de l'empilement de grille. Ce motif sacrificiel est ensuite retiré, une fois les espaceurs réalisés. Ce mode de réalisation alternatif est un procédé de type « gate last ».

## Revendications

1. Procédé de formation d'espaceurs (112) sur un motif de grille (1) de transistor comprenant les étapes successives suivantes :
- Fournir un empilement comprenant au moins une couche active (10) s'étendant selon un plan basal et le motif de grille (1) surmontant la couche active (10), le motif de grille (1) présentant des flancs latéraux (5) s'étendant selon des plans perpendiculaires à la couche active (10),
- Déposer sur le motif de grille (1) et la couche active (10) une première couche (11) en un premier matériau diélectrique présentant une épaisseur e1, la première couche comprenant des premières portions latérales (11L) recouvrant les flancs latéraux du motif de grille (1), et comprenant en outre des premières portions basales (11B) s'étendant parallèlement audit plan basal et recouvrant la couche active (10),
- Réaliser une modification anisotrope (200) de ladite première couche (11) selon une direction parallèle aux flancs latéraux (5), de façon à obtenir des premières portions basales modifiées (11M) en conservant des premières portions latérales non modifiées (11L),
- Effectuer au moins une séquence comprenant les étapes suivantes :
∘ Déposer sur ladite première couche (11) une deuxième couche (12) en un deuxième matériau diélectrique présentant une épaisseur e2 et comprenant des deuxièmes portions latérales (12L) recouvrant les premières portions latérales non modifiées (11L), lesdites deuxièmes portions latérales (12L) étant directement au contact des premières portions latérales non modifiées (11L), et des deuxièmes portions basales (12B), s'étendant parallèlement au plan basal et recouvrant les premières portions basales modifiées (11M),
∘ Réaliser une gravure anisotrope de ladite deuxième couche (12) selon ladite direction parallèle aux flancs latéraux (5), de façon à éliminer les deuxièmes portions basales (12B) et en conservant une partie au moins des deuxièmes portions latérales non modifiées (12L),
- Retirer les premières portions basales modifiées (11M) qui sont mises à nu à l'issue de ladite gravure anisotrope de ladite deuxième couche (12) en conservant les premières et deuxièmes portions latérales (11L, 12L) non modifiées pour former des espaceurs (112), par gravure sélective du premier matériau diélectrique modifié vis-à-vis du premier matériau diélectrique non modifié, du deuxième matériau diélectrique et du matériau de la couche active (10).

2. Procédé selon la revendication précédente dans lequel le dépôt des première (11) et deuxième (12) couches et la modification anisotrope sont effectués au sein d'un même réacteur.

3. Procédé selon l'une quelconque des revendications précédentes dans lequel e1 est inférieure à e2, de préférence e1 < 0,5*e2.

4. Procédé selon l'une quelconque des revendications précédentes dans lequel l'épaisseur e1 est inférieure ou égale à 2 nm (10⁻⁹ mètres).

5. Procédé selon la revendication précédente dans lequel ladite séquence est réitérée un nombre de fois permettant d'obtenir des espaceurs (112) présentant une épaisseur E = e1 + e2 avec E ≤ 30 nm, de préférence E ≤ 15 nm.

6. Procédé selon l'une quelconque des revendications précédentes dans lequel le dépôt des première (11) et deuxième (12) couches est un dépôt conforme, de sorte que les premières portions latérales (11L) et basales (11B) présentent sensiblement la même épaisseur e1, et que les deuxièmes portions latérales (12L) et basales (12B) présentent sensiblement la même épaisseur e2.

7. Procédé selon l'une quelconque des revendications précédentes dans lequel le dépôt des première et deuxième couches se fait par un procédé de dépôt assisté par plasma, de préférence pris parmi un dépôt de couches atomiques assisté par plasma (PEALD) et un dépôt chimique en phase vapeur assisté par plasma (PECVD).

8. Procédé selon l'une quelconque des revendications précédentes dans lequel la modification anisotrope se fait par implantation d'ions provenant d'un plasma selon la direction parallèle aux flancs latéraux (5), les ions étant à base d'hydrogène ou d'hélium.

9. Procédé selon l'une quelconque des revendications précédentes, dans lequel la modification anisotrope (200) de ladite première couche (11) est réalisée de façon à obtenir des premières portions basales modifiées (11M) selon toute leur épaisseur e1 et en conservant les premières portions latérales (11L) non modifiées.

10. Procédé selon l'une quelconque des revendications précédentes dans lequel la gravure anisotrope de la deuxième couche se fait par des ions provenant d'un plasma selon la direction parallèle aux flancs latéraux (5), à partir d'au moins une espèce plus lourde que l'hélium et de préférence prise parmi l'argon (Ar).

11. Procédé selon la revendication précédente dans lequel l'au moins une espèce n'est pas du type CₓH_{y} où x est la proportion de carbone (C) et y est la proportion d'hydrogène (H).

12. Procédé selon l'une quelconque des revendications précédentes dans lequel le premier matériau diélectrique et le deuxième matériau diélectrique sont choisis parmi le SiN, le SiCO, le SiC, le SiCN, le SiOCN, le SiCBN, le SiOCH, le CBN, le BN, le SiCBO et le SiO2.

13. Procédé selon l'une quelconque des revendications précédentes dans lequel le premier matériau diélectrique et le deuxième matériau diélectrique sont identiques.

14. Procédé selon l'une quelconque des revendications précédentes dans lequel la gravure sélective du premier matériau diélectrique modifié est une gravure humide à l'aide d'une solution prise parmi : une solution à base d'acide fluorhydrique (HF), la solution à base d'acide fluorhydrique (HF) présentant de préférence une dilution en HF comprise entre 0.1% et 5% en masse.

15. Procédé de réalisation d'un transistor de type FinFET ou FDSOI comprenant un empilement comprenant au moins une couche active (10) s'étendant selon un plan basal et un motif de grille (1) surmontant la couche active (10), le motif de grille (1) présentant des flancs latéraux (5) s'étendant selon des plans sensiblement perpendiculaires à la couche active (10), le procédé comprenant un procédé de formation d'espaceurs (112) sur le motif de grille (1) selon l'une quelconque des revendications précédentes.

## Patentansprüche

1. Verfahren zum Bilden von Abstandshaltern (112) auf einem Transistor-Gate-Muster (1), umfassend die folgenden aufeinanderfolgenden Schritte:
- Bereitstellen eines Stapels, der mindestens eine aktive Schicht (10), die sich entlang einer Basisebene erstreckt, und das Gate-Muster (1), das die aktive Schicht (10) überragt, umfasst, wobei das Gate-Muster (1) seitliche Flanken (5) aufweist, die sich entlang Ebenen senkrecht zur aktiven Schicht (10) erstrecken,
- Abscheiden einer ersten Schicht (11) aus einem ersten dielektrischen Material mit einer Dicke e1 auf dem Gate-Muster (1) und der aktiven Schicht (10), wobei die erste Schicht erste seitliche Abschnitte (11L) umfasst, die die seitlichen Flanken des Gate-Musters (1) bedecken und ferner erste Basisabschnitte (11B) umfasst, die sich parallel zur Basisebene erstrecken und die aktive Schicht (10) bedecken,
- Durchführen einer anisotropen Modifikation (200) der ersten Schicht (11) in einer Richtung parallel zu den seitlichen Flanken (5), so dass unter Beibehaltung der ersten nicht modifizierten seitlichen Abschnitte (11L) erste modifizierte Basisabschnitte (11M) erhalten werden,
- Ausführen mindestens einer Sequenz, die die folgenden Schritte umfasst:
∘ Abscheiden einer zweiten Schicht (12) aus einem zweiten dielektrischen Material mit einer Dicke e2 und mit zweiten seitlichen Abschnitten (12L), die die ersten nicht modifizierten seitlichen Abschnitte (11L) bedecken, auf der ersten Schicht (11), wobei die zweiten seitlichen Abschnitte (12L) direkt in Kontakt mit den ersten nicht modifizierten seitlichen Abschnitten (11L) stehen, und mit zweiten Basisabschnitten (12B), die sich parallel zur Basisebene erstrecken und die ersten modifizierten Basisabschnitte (11M) bedecken,
∘ Durchführen eines anisotropen Ätzens der zweiten Schicht (12) in der Richtung parallel zu den seitlichen Flanken (5), um die zweiten Basisabschnitte (12B) abzutragen und mindestens einen Teil der zweiten nicht modifizierten seitlichen Abschnitte (12L) beizubehalten,
- Entfernen der ersten modifizierten Basisabschnitte (11M), die nach dem anisotropen Ätzen der zweiten Schicht (12) freigelegt werden, während die ersten und die zweiten nicht modifizierten seitlichen Abschnitte (11L, 12L) beibehalten werden, um Abstandshalter (112) durch selektives Ätzen des ersten modifizierten dielektrischen Materials in Bezug auf das erste nicht modifizierte dielektrische Material, das zweite dielektrische Material und das Material der aktiven Schicht (10) zu bilden.

2. Verfahren nach dem vorhergehenden Anspruch, wobei das Abscheiden der ersten (11) und der zweiten (12) Schicht und die anisotrope Modifikation innerhalb des gleichen Reaktors durchgeführt werden.

3. Verfahren nach einem der vorhergehenden Ansprüche, wobei e1 kleiner als e2 ist, vorzugsweise e1 < 0,5*e2.

4. Verfahren nach einem der vorhergehenden Ansprüche, wobei die Dicke e1 kleiner oder gleich 2 nm (10⁻⁹ Meter) ist.

5. Verfahren nach dem vorhergehenden Anspruch, wobei die Sequenz mehrmals wiederholt wird, um das Erhalten von Abstandshaltern (112) mit einer Dicke E = e1 + e2, wobei E ≤ 30 nm, vorzugsweise E ≤ 15 nm, zu ermöglichen.

6. Verfahren nach einem der vorhergehenden Ansprüche, wobei die Abscheidung der ersten (11) und der zweiten (12) Schicht eine konforme Abscheidung ist, so dass die ersten seitlichen (11L) und Basisabschnitte (11B) im Wesentlichen die gleiche Dicke e1 aufweisen und dass die zweiten seitlichen (12L) und Basisabschnitte (12B) im Wesentlichen die gleiche Dicke e2 aufweisen.

7. Verfahren nach einem der vorhergehenden Ansprüche, wobei die Abscheidung der ersten und der zweiten Schicht durch ein plasmaunterstütztes Abscheidungsverfahren erfolgt, vorzugsweise ausgewählt aus der plasmaunterstützten Atomschichtabscheidung (PEALD) und einer plasmaunterstützten chemischen Gasphasenabscheidung (PECVD).

8. Verfahren nach einem der vorhergehenden Ansprüche, wobei die anisotrope Modifikation durch Implantation von Ionen erfolgt, die aus einem Plasma entlang der Richtung parallel zu den seitlichen Flanken (5) kommen, wobei die Ionen auf Wasserstoff- oder Heliumbasis sind.

9. Verfahren nach einem der vorhergehenden Ansprüche, wobei die anisotrope Modifikation (200) der ersten Schicht (11) derart durchgeführt wird, dass erste modifizierte Basisabschnitte (11M) in ihrer ganzen Dicke e1 erhalten werden und die ersten nicht modifizierten seitlichen Abschnitte (11L) beibehalten werden.

10. Verfahren nach einem der vorhergehenden Ansprüche, wobei das anisotrope Ätzen der zweiten Schicht durch Ionen erfolgt, die aus einem Plasma entlang der Richtung parallel zu den seitlichen Flanken (5) kommen und von mindestens einer Spezies stammen, die schwerer ist als Helium und vorzugsweise aus Argon (Ar) ausgewählt ist.

11. Verfahren nach dem vorhergehenden Anspruch, wobei die mindestens eine Spezies nicht vom Typ CₓH_{y} ist, wobei x der Anteil an Kohlenstoff (C) und y der Anteil an Wasserstoff (H) ist.

12. Verfahren nach einem der vorhergehenden Ansprüche, wobei das erste dielektrische Material und das zweite dielektrische Material aus SiN, SiCO, SiC, SiCN, SiOCN, SiCBN, SiOCH, CBN, BN, SiCBO und SiO2 ausgewählt werden.

13. Verfahren nach einem der vorhergehenden Ansprüche, wobei das erste dielektrische Material und das zweite dielektrische Material identisch sind.

14. Verfahren nach einem der vorhergehenden Ansprüche, wobei das selektive Ätzen des ersten modifizierten dielektrischen Materials ein Nassätzen unter Verwendung einer Lösung ist, die ausgewählt ist aus: Einer Lösung auf Basis von Fluorwasserstoffsäure (HF), wobei die Lösung auf Basis von Fluorwasserstoffsäure (HF) vorzugsweise eine HF-Verdünnung zwischen 0,1 Massen-% und 5 Massen-% aufweist.

15. Verfahren zum Herstellen eines Transistors vom FinFET- oder FDSOI-Typ, der einen Stapel umfasst, der mindestens eine aktive Schicht (10), die sich entlang einer Basisebene erstreckt, und ein Gate-Muster (1), das die aktive Schicht (10) überragt, umfasst, wobei das Gate-Muster (1) seitliche Flanken (5) aufweist, die sich entlang Ebenen im Wesentlichen senkrecht zur aktiven Schicht (10) erstrecken, wobei das Verfahren ein Verfahren zum Bilden von Abstandshaltern (112) auf dem Gate-Muster (1) nach einem der vorhergehenden Ansprüche umfasst.

## Claims

1. A method for forming spacers (112) on a transistor gate pattern (1) comprising the following successive steps:
- providing a stack comprising at least one active layer (10) extending along a basal plane and the gate pattern (1) being on top of the active layer (10), the gate pattern (1) having side flanks (5) extending along planes perpendicular to the active layer (10),
- depositing onto the gate pattern (1) and the active layer (10) a first layer (11) of a first dielectric material having a thickness e1, the first layer comprising first side portions (11L) covering the side flanks of the gate pattern (1), and further comprising first basal portions (11B) extending in parallel to said basal plane and covering the active layer (10),
- making an anisotropic modification (200) in said first layer (11) along a direction parallel to the side flanks (5), so as to obtain modified first basal portions (11M) while keeping first side portions (11L) unmodified,
- performing at least one sequence comprising the following steps:
o depositing onto said first layer (11) a second layer (12) of a second dielectric material having a thickness e2 and comprising second side portions (12L) covering the unmodified first side portions (11L), said second side portions (12L) being directly in contact with the unmodified first side portions (11L), and second basal portions (12B), extending in parallel to the basal plane and covering the modified first basal portions (11M),
o making an anisotropic etching of said second layer (12) along said direction parallel to the side flanks (5), so as to remove the second basal portions (12B) and while keeping at least part of the second side portions (12L) unmodified,
- withdrawing the modified first basal portions (11M) which are bared at the end of said anisotropic etching of said second layer (12) while keeping the first and second side portions (11L, 12L) unmodified to form spacers (112), by selectively etching the first modified dielectric material with respect to the unmodified first dielectric material, the second dielectric material and the material of the active layer (10).

2. The method according to the preceding claim wherein the deposition of the first (11) and second (12) layers and the anisotropic modification are performed within a same reactor.

3. The method according to any of the preceding claims wherein e1 is less than e2, preferably e1 < 0.5*e2.

4. The method according to any of the preceding claims wherein the thickness e1 is less than or equal to 2 nm (10⁻⁹ metres).

5. The method according to the preceding claim wherein said sequence is reiterated a number of times for obtaining spacers (112) having a thickness E = e1 + e2 with E ≤ 30 nm, preferably E ≤ 15 nm.

6. The method according to any of the preceding claims wherein the deposition of the first (11) and second (12) layers is a conformal deposition, so that the first side (11L) and basal (11B) portions substantially have the same thickness e1, and that the second side (12L) and basal (12B) portions substantially have the same thickness e2.

7. The method according to any of the preceding claims wherein the deposition of the first and second layers is done by a plasma-enhanced deposition method, preferably taken from a plasma-enhanced atomic layer deposition (PEALD) and a plasma-enhanced chemical vapour deposition (PECVD).

8. The method according to any of the preceding claims wherein the anisotropic modification is done by implanting ions coming from a plasma along the direction parallel to the side flanks (5), the ions being based on hydrogen or helium.

9. The method according to any of the preceding claims, wherein the anisotropic modification (200) of said first layer (11) is carried out so as to obtain modified first basal portions (11M) along their entire thickness e1 and while keeping the first side portions (11L) unmodified.

10. The method according to any of the preceding claims wherein the anisotropic etching of the second layer is done by ions coming from a plasma along the direction parallel to the side flanks (5), from at least one species heavier than helium and preferably taken from argon (Ar).

11. The method according to the preceding claim wherein the at least one species is not of the CₓH_{y} type where x is the proportion of carbon (C) and y is the proportion of hydrogen (H).

12. The method according to any of the preceding claims wherein the first dielectric material and the second dielectric material are selected from SiN, SiCO, SiC, SiCN, SiOCN, SiCBN, SiOCH, CBN, BN, SiCBO and SiOz.

13. The method according to any of the preceding claims wherein the first dielectric material and the second dielectric material are identical.

14. The method according to any of the preceding claims wherein the selective etching of the first modified dielectric material is wet etching using a solution taken from: a solution based on hydrofluoric acid (HF), the solution based on hydrofluoric acid (HF) preferably having a HF dilution of between 0.1% and 5% by mass.

15. A method for making a FinFET or FDSOI type transistor comprising a stack comprising at least one active layer (10) extending along a basal plane and a gate pattern (1) being on top of the active layer (10), the gate pattern (1) having side flanks (5) extending along planes substantially perpendicular to the active layer (10), the method comprising a method for forming spacers (112) on the gate pattern (1) according to any of the preceding claims.
